(19) **Europäisches Patentamt / European Patent Office / Office européen des brevets**

(11) **EP 1 777 824 A1**

(12) # EUROPÄISCHE PATENTANMELDUNG

(43) Veröffentlichungstag:
25.04.2007 Patentblatt 2007/17

(51) Int Cl.:
*H03M 1/10* (2006.01)  *G01R 31/00* (2006.01)

(21) Anmeldenummer: 06122391.3

(22) Anmeldetag: 17.10.2006

(84) Benannte Vertragsstaaten:
AT BE BG CH CY CZ DE DK EE ES FI FR GB GR HU IE IS IT LI LT LU LV MC NL PL PT RO SE SI SK TR
Benannte Erstreckungsstaaten:
AL BA HR MK YU

(30) Priorität: 24.10.2005 DE 102005050768

(71) Anmelder: ROBERT BOSCH GMBH
70442 Stuttgart (DE)

(72) Erfinder:
• **Angerbauer, Ralf**
71701 Schwieberdingen (DE)
• **Boehl, Eberhard**
72768 Reutlingen (DE)
• **Fehrenbacher, Berthold**
71706 Markgroeningen (DE)
• **Kottke, Thomas**
71139 Ehningen (DE)

(54) **Parametrischer ADC-Test**

(57) Verfahren und Vorrichtung zum Testen von A/D-Wandlern auf Genauigkeit und/oder Sicherheit der Transformation analoger Signale in binären Werte, dadurch gekennzeichnet, dass lediglich zwei an einander komplementär gekoppelten analogen Referenzmesswerte, die mit einer definierten Fehlerbandbreite behaftet sind, als Prüfgrößen dienen, und aus den Annahmen größtmöglicher Fehler dieser Referenzgrößen die erwartete Genauigkeit transformierter Soll-Digitalwerte errechnet wird, und aus den statistischen Messergebnissen auf die Genauigkeit des A/D-Wandlers Rückschlüsse gemacht werden.

EP 1 777 824 A1

**Beschreibung**

Die Erfindung betrifft ein Verfahren und eine Vorrichtung zum Testen von ADC's (Analog to Digital Converter; A/D-Wandler) auf deren Genauigkeit, analoge elektrische Signale in digitale Werte zu transformieren.

Die nutzbare Genauigkeit wird durch Nichtlinearitäten im analogen Schaltungsteil des ADC's verringert. Deswegen ist die Genauigkeit eines ADC meist kleiner als die Auflösung. Die erforderliche Genauigkeit für einen bestimmten Anwendungsfall kann darüber hinaus von der möglichen Genauigkeit abweichen. Insbesondere für sicherheitskritische Anwendungen haben fehlerhafte Abweichungen in den höherwertigen Bits meist kritischere Folgen als in den niederwertigsten Bits. Es ist deshalb für eine solche Anwendung vorzugeben, welche Bits mindestens fehlerfrei sein müssen, um eine bestimmte Sicherheitsklasse zu erreichen. Es ist dann von Vorteil, die Fehlerfreiheit genau dieser Bits durch einen Test in der Anwendungsumgebung durchzuführen.

Ein hochwertiger Test eines ADC erfordert nach einem bekannten Verfahren das Vorliegen mehrerer sehr präziser Referenzwertquellen, deren analoge Werte in dem zu testenden ADC transformiert werden und die Ergebnisse mit den erwarteten digitalen Referenz-Sollwerten verglichen werden. Nach einem anderen Verfahren muss eine zusätzliche Hardware in den Test miteinbezogen werden (Boehl/Lindenkreuz/Stephan: The Fail-Stop Controller AE11, ITC 1997, paper 24.1).

Beide Verfahren versagen jedoch, wenn wie im modernen Elektronikumfeld üblich, die ADC's auf hoch integrierten Halbleiterbausteinen inklusive Spannungsquellen und zusätzlicher Hardware implementiert werden. Dann ist gar kein Test des Eingangsmultiplexers des ADC möglich. Wenn als Testreferenzspannungsquellen nur die Masse und die Betriebsspannung vorliegen, dann ist auch ein für ADC's üblicher, parametrischer Test nur unvollkommen durchführbar. Die parametrischen Tests sind statistische Verfahren, die auf Messreihen angewendet werden - im einfachsten Fall ist es ein t-Test (Mittelwertvergleich bei 2 Stichproben).

Weitere Verfahren erfordern Referenzwerte, die sehr präzise im Bereich der Auflösungsgenauigkeit des ADC's liegen müssen, um seine Bewertung zu ermöglichen.

Die Bitstellen eines digitalen Wertes, dargestellt am besten in Binärform, haben eine von rechts nach links zunehmende Wertigkeit (Bitwertigkeit oder Stelligkeit genannt) - beispielsweise Bit Nummer 10 von rechts entspricht einer Zahl 29, während Bit Nummer 3 einer Zahl 22 entspricht - falls die Binärzahl nicht von links nach rechts darstellt wird, was mitunter auch vorkommt. Hieraus wird ersichtlich, dass ein Bit-Fehler unterschiedlich große Auswirkung hat, je nach seinem Stellenwert in einer Binärzahl. Ein MSB-Fehler (most significant bit; höchstwertigstes Bit) hat hierdurch beispielsweise wesentlich kritischere Folgen, als ein LSB-Fehler (least significant bit; niederwertigstes Bit). Die Auswirkungen sind gravierend sowohl bei z. B digitalen Audio- wie bei sicherheitskritischen Anwendungen. Für jede Anwendung existiert eine eigene Eingrenzung der Wichtigkeit einzelner Bitstellen in dem durch ADC bereitgestellten Binärwert. Die Angabe der Güte eines ADC geschieht durch die Angabe der Nummer des sicheren Bits i eines Datenworts mit n-Bits, wobei $(n-1) > i > 0$. In den Tests ist es wichtig, dass jedes Bit mindestens einmal von 0 auf 1 umschaltet, um z. B einen stuck-at Fehler feststellen zu können.

Aufgabe der Erfindung ist es, ein Verfahren und eine Vorrichtung anzugeben, die auch bei chip-intern vorliegenden Versorgungsspannungen und zusätzlicher Hardware präzise funktionieren, wobei Testmessungen vor Ort erfolgen können und mit möglichst wenigen Testmessungen und verminderten Anforderungen an die Präzision der Referenzspannungen oder -ströme festgestellt werden kann, ob der ADC für die Bitwerte n-1 ...i korrekt funktioniert.

Erfindungsgemäß werden lediglich zwei Referenz-Spannungswerte zur Verfügung gestellt, die aus der Betriebsspannung und der Masse gebildet werden. Die zur Verfügung stehende Betriebsspannung wird durch einen einfachen Spannungsteiler an zwei Widerständen geteilt, so dass die geteilte Spannung etwa der halben Spannung entspricht, die der ADC an seinem Eingang transformieren kann. Durch Vertauschung der beiden Widerstände kommen die Größenabweichungen und die Fehlertoleranzen der Widerstände genau andersherum zum Tragen und es ergibt sich eine zweite Referenzspannung, die sich von der vorherigen um einen Wert unterscheidet, der auf die Fehlertoleranzen der Widerstände zurück zu führen ist, bzw. zusätzlich noch auf den unterschiedlichen Widerstandswert, falls sie nicht gleich groß gewählt wurden.

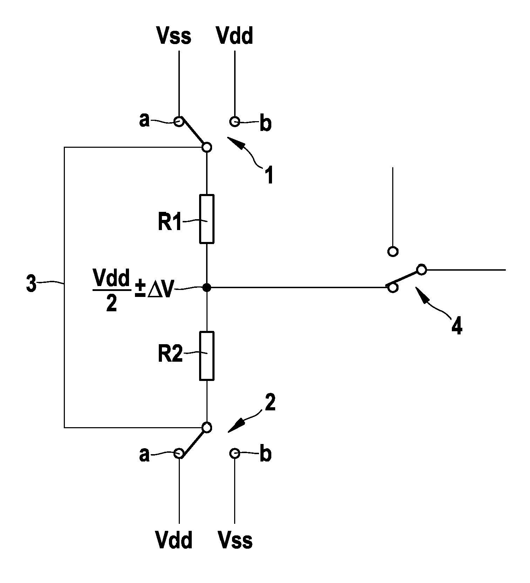

Die geteilte Spannung wird dem analogen Eingang des ADC zugeführt und ein weiteres Mal gemessen, nach dem durch die Schalteranordnung die Polung der Spannung an dem Spannungswandler umgekehrt wird, was mit der vorgeschlagenen Schaltung einem Vertauschen der beiden Widerstände gleich kommt. Dadurch wird der ADC gezwungen in beiden Fällen einen Wert zu transformieren, der sich einmal etwas unterhalb der halben Eingangsspannungsweite des ADC befand, und anschließend einen Spannungswert oberhalb dieses Mittelpunktes. Das gewährleistet der Spannungsteiler, denn lag die Spannung zuerst unterhalb, dann muss sie nach Vertauschen der Widerstände zwangsläufig oberhalb der halben Eingangsspannungsweite des ADC liegen. Die einzige Figur verdeutlicht diese Anordnung. Die beiden Referenzspannungen miteinander addiert würden die angelegte Betriebsspannung ergeben, und sind durch diese Summenbildung im mathematischen Sinne gekoppelt. Möglich ist auch, mehr als zwei Messungen vorzunehmen, um höhere Genauigkeitswerte zu erzielen bzw. eine statistische Aussage zur Genauigkeit zu treffen.

Es kann bereits an nur einem der Referenzwerte durch die statistischen Messwertreihen prinzipiell getestet werden ob der ADC funktioniert - allerdings hat man dann keine Gewähr, dass nicht doch ein Fehler unerkannt vorliegt und der ADC für beliebige Eingangswerte funktioniert. Wird z. B ein Test mit dem erwarteten Ergebnis 011111xxx...x durchgeführt und das Messergebnis stimmt damit überein, so kann es doch sein, dass der ADC durch einen stuck-at Fehler am MSB unabhängig vom Eingangssignal immer eine '0' ausgibt und nur die unteren Bits variiert. In diesem Fall wäre bei einer Messung des vollen Betriebsspannungswertes binär der Wert 011111111...1 ausgegeben, anstatt des richtigen Wertes 1111111111...1 und man hätte keine Möglichkeit, dieses Fehlverhalten festzustellen. Deshalb ist es wichtig, mindestens so viele Testwerte zur Verfügung zu haben, dass bei den digitalen Ausgangswerten für jedes relevante Bit mindestens einmal eine 0 und mindestens einmal eine 1 enthalten ist.

In binärer Form entspricht - nach einer gebräuchlichen Konvention - das höchstwertige Bit, das MSB, oft dem Vorzeichen und dient der Darstellung negativer und positiver Zahlen, wobei MSB=0 einen positiven und MSB=1 einen negativer Zahlen bereich darstellt. Hierbei handelt es sich jedoch um einen lediglich positiven Spannungsbereich, der auch mit MSB=1 abgebildet wird - denn die ADC's können ohne spezielle Maßnahmen nur ein positives Signal transformieren. Mit der Spannungsteileranordnung nach der Figur wird erreicht, dass genau der Übergang zum MSB=1 zuverlässig getroffen wird. Dies einmal unterhalb des Übergangs und einmal oberhalb davon, und somit gewährleistet wird, dass bei beiden Referenztestwerten die Bits komplementär umgeschaltet werden, was eine wichtige Voraussetzung ist, um einen stuck-at Fehler am MSB zu Erkennen, und der Forderung zu genügen, dass jedes Bit mindestens einmal von 0 auf 1 umschaltet.

Gemäß Anordnung in der Figur wird bei der Wandlung des Spannungswertes 1 in Schalterstellung a) ein Binärwert 01111....1xxx....xxx und für den Spannungswert 2 in Schalterstellung b) ein Wert 100000...0xxx...xx erhalten, wobei der Wert x einem beliebigen, zufälligen binären Wert, und die Position vor dem obersten x der Bitstelle i entspricht, die ein Grenzwert für die Präzision der Referenzwertanordnung und somit auch des ADC darstellt.

Das binäre Ergebnis lässt sich mathematisch als eine Folge aus Zweier-Potenzen darstellen:

1. Spannungswert maximal, bei Doppel-Schalterstellung a), d.h. alle x-Werte nach Bit i sind gleich 1, und MSB=0:

$$(2^{n-2} + 2^{n-3} + ... + 2^i + 2^{i-2} + 1)*(V_{dd}/(2^n))$$

1. Spannungswert minimal, bei Schalterstellung a), d.h. alle x-Werte nach Bit i sind 0, MSB=0:

$$(2^{n-2} + 2^{n-3} + ... + 2^i)*(V_{dd}/(2^n))$$

2. Spannungswert maximal, bei Schalterstellung b), d.h. alle x-Werte rechts von Bit i sind 1, Bit i =0, MSB=1:

$$(2^{n-1} + 2^{i-1} + 2^{i-2} + 1)*(V_{dd}/(2^n))$$

2. Spannungswert minimal, bei Schalterstellung b), d.h. alle x-Werte nach MSB sind 0, MSB=1:

$$(2^{n-1})*(V_{dd}/(2^n))$$

Es lassen sich zusätzliche Toleranzen des ADC's in die Testmessung einbeziehen, indem der Zahlenbereich eingeschränkt wird. Dazu kann z. B der Maximalwert in der Klammer um 1 vermindert und der Minimalwert um 1 erhöht werden.

Die Referenzspannungen müssen nicht unbedingt nach der Figur durch einen Spannungsteiler bereit gestellt werden, jedoch lässt sich die erreichbare Messgenauigkeit des ADC anhand der Genauigkeit der gewählten Widerstände des Spannungsteilers im Voraus theoretisch bestimmen und auf den errechneten Sollwert überprüfen. Das nachstehende Rechenbeispiel verdeutlicht dies.

Werden für die Widerstände R1 und R2 im Spannungsteiler in der Figur aus der Normreihe E96 nach DIN IEC 63 mit 1% relativer Fehlertoleranz die zwei folgenden auswählt, ein R1=866 Ohm und ein R2=887 Ohm Widerstand, dann ergeben sich rechnerisch Widerstände mit den worst-case Toleranzwerten:

a) R1' = 874,66 Ohm und R2' = 878,13 Ohm mit dem Mittelwert R' = 876,395 Ohm

b) R1" = 857,34 Ohm und R" = 895,87 Ohm mit dem Mittelwert R" = 876,605 Ohm.

Liegt R1 an Vss (Schalterstellung a), 1.Spannungswert) dann liefert ein korrekter ADC einen binären Sollwert für die angelegte Spannung von 011111xxx...x, also 6 Bitstellen Genauigkeit. Dies deshalb, weil R1" nur um 1,1 % vom Mittelwert R" abweicht, was unter $1/2^6$ = 1,563% liegt. Nach bekannten Rechenregeln sagt der Potenzwert 6 für die 6 Bits Genauigkeit dabei aus, dass die garantierte Auflösungsgenauigkeit des Spannungsteilers 6 Bit beträgt, mit einer Abweichung vom Mittelwert weniger als $1/2^6$. In Schalterstellung b) in der Figur liefert der ADC den ebenso sechsstellig genauen Sollbinärwert 100000xxx...xx.

Somit lässt sich eine Messanordnung realisieren, die einen vorher bestimmten theoretischen digitalen Wert liefert, der durch statistische Messreihen verifiziert werden kann - was mitunter die Aussage zulässt, dass dann auch der ADC selbst keinen zusätzlichen Beitrag zum Fehler geliefert hat und die angelegte Spannung korrekt transformiert, wenn der gemessene Fehler unterhalb des theoretischen Wertes bleibt. Seine Genauigkeit ist dann zumindest so gut wie die des Spannungsteilers. Die unteren, nach theoretischem Ansatz unsicheren Bits interessieren nicht, wenn lediglich die korrekte Funktion des ADC's für die geforderte Anzahl höherer Bits überprüft werden soll. Dann liegen zwei binäre, komplementär zu einander positionierte Sollwerte vor und es werden nur die vorhergesagten sicheren Bits betrachtet. Wenn diese stimmen, lässt sich daraus ableiten, dass der ADC für die geforderte Auflösung funktioniert. Im minimalistischen Anwendungsfall genügen dazu lediglich je eine Messung für die beiden komplementären Referenzwerte - weiteren Messversuche erhöhen jedoch die Aussagekraft der Tests. Das nachfolgende Rechenbeispiel für weniger genaue Anforderungen verdeutlicht das Prinzip noch einmal.

Danach werden mit R1=750 Ohm 5% und R2=910 Ohm 5% die Sollbinärwerte 011xxxx...xx und 100xxxx...x erhalten, weil die maximale Abweichung des Widerstandswertes R1" vom Mittelwert R" hierbei 7,3% beträgt, was kleiner ist als $1/2^3$ = 12,5%. Somit kann der Spannungswert mit einer garantierten Auflösungsgenauigkeit von 3 Bit abweichend vom Mittelwert bereit gestellt werden.

Je nach geforderter Genauigkeit an den parametrischen Test des ADC, d. h an die Stelligkeit der sicheren Bitposition i, kann ein Spannungsteiler durch die Beschaffenheit der Widerstände mit niedrigeren oder höheren Toleranzen bereit gestellt werden, um so beispielsweise ein reales Signal bestimmter Fehlerbandbreite zu simulieren.

Werden in einem integrierten Chipherstellungsprozess gemeinsam mit der Schaltung des ADC die Widerstände R1 und R2 implementiert, lassen sich besonders präzise Widerstandsverhältnisse einstellen, wodurch die Testmessung des ADC gleichfalls präziser wird. Die zwei Referenztestspannungen müssen aber nicht unbedingt durch einen Spannungsteiler bereitgestellt werden - sie können auch anders vorliegen - wichtig ist, dass deren statistischen Fehlertoleranzen vorher bestimmbar sind und sie einmal unterhalb und einmal oberhalb der halben Eingangsspannungsweite liegen, um den MSB und alle sicheren Bits einmal komplementär umzuschalten.

Nach dem vorgestellten Verfahren und der vorgestellten Vorrichtung lassen sich alle Arten von ADC's testen - die mit Komparatoren nach Sägezahnverfahren ebenso wie die nach Dual-Slope oder nach Kompensations- oder Direktverfahren konzipierten.

Die Schaltung der einzigen Figur lässt sich auf einem Halbleiterbauelement zusammen mit den Umschaltern und dem ADC im gemeinsamen Herstellungsprozess unterbringen und der Test des ADC somit automatisieren. Ein Hard- oder Softwareprogramm kann diese Tests ausführen, auswerten und das Ergebnis zur weiteren Verarbeitung zur Verfügung stellen. Hierzu müssen die Schalter ansteuerbar, z. B als Transistoren ausgeführt werden. Ebenso kann diese Schaltung auf einer gemeinsamen mit dem ADC elektronischen Platine untergebracht sein, oder beispielsweise als ein Messgerät ausgeführt werden.

Die Figur zeigt eine vorteilhafte Schaltungsanordnung gemäß der vorliegenden Erfindung. Die Referenz-Widerstände R1 und R2 des Spannungsteilers werden von einem symbolisch dargestellten Doppelschalter mit dem Synchronisationsbügel 3 angesteuert, der die Umschalter 1 und 2 abwechselnd zwischen Betriebsspannung Vdd und Masse Vss so umschaltet, dass der Vorgang einem Vertauschen der beiden Widerstände R1 und R2 gleicht. An dem Knotenpunkt zwischen den beiden Widerständen R1, R2 wird die geteilte Betriebsspannung abgegriffen und dem ADC zugeführt. Ein Umschalter 4 erlaubt die Umschaltung des ADC von der Spannungsteiler-Testschaltung auf ein Nutzsignal, hier beispielsweise von einem Sensor.

**Patentansprüche**

1. Verfahren zum Testen von A/D-Wandlern auf Genauigkeit der Transformation analoger Signale in binären Werte, **dadurch gekennzeichnet, dass** lediglich zwei aneinander komplementär gekoppelte analoge Referenzmesswerte, die mit einer definierten Fehlerbandbreite behaftet sind, als Prüfgrößen dienen, und aus den Annahmen größtmöglicher Fehler dieser Referenzgrößen die erwartete Genauigkeit transformierter Soll-Digitalwerte errechnet wird, wobei aus den Messergebnissen auf eine Mindestgenauigkeit des A/D-Wandlers geschlossen wird.

2.  Verfahren zum Testen von A/D-Wandlern auf Sicherheit der Transformation analoger Signale in binären Werte, **dadurch gekennzeichnet, dass** lediglich zwei aneinander gekoppelte analoge Referenzmesswerte, die mit einer definierten Fehlerbandbreite behaftet sind, als Prüfgrößen dienen, und aus den Annahmen größtmöglicher Fehler dieser Referenzgrößen die erwartete Sicherheit transformierter Soll-Digitalwerte errechnet wird, und aus den mindestens zwei komplementären Messergebnissen auf die Fehlerfreiheit von einer vorher definierten Anzahl von Bits geschlossen wird.

3.  Verfahren nach Anspruch 1 oder 2, bei dem die zwei analogen Referenzmesswerte so gewählt werden, dass einer davon um einen Betrag unterhalb der halben Eingangssignalweite des A/D-Wandlers liegt, und der zweite Referenzwert oberhalb von dieser Weite liegt, so dass die erwarteten binären Sollwerte **dadurch** garantiert zumindest in den sicheren Bits bitweise komplementär sind.

4.  Verfahren nach einem der vorstehenden Ansprüche, bei dem sich die Anforderungen an die Genauigkeit des Messverfahrens in Schritten von nur einem Bit variieren lassen.

5.  Verfahren zum Testen von A/D-Wandlern auf Genauigkeit der Transformation analoger Signale in binären Werte, **dadurch gekennzeichnet, dass** mindestens ein analoger Referenzwert mit einer definierten Fehlerbandbreite als Prüfgröße dient, und aus den Annahmen größtmöglicher Fehler dieser Referenzgröße die erwartete Genauigkeit des transformierten Soll-Digitalwertes errechnet wird, und aus den statistischen Messergebnissen auf die Genauigkeit des A/D-Wandlers Rückschlüsse gezogen werden.

6.  Vorrichtung zum Testen von A/D-Wandlern auf Genauigkeit der Transformation analoger Signale in binären Werte, **dadurch gekennzeichnet, dass** die Messschaltung einen aus zwei Widerständen (R1, R2) bestehenden Spannungsteiler zur Verfügung stellt, dessen Mittelknoten an den Eingang des ADC geführt wird, und beide Aussenknoten je an einen Umschalter (1, 2) angeschlossen sind, die synchron umgeschaltet werden, und die an ihren Kontakten angelegte Spannung damit umpolen, wobei die Masse (Vss) und die Betriebsspannung (Vdd) des Spannungsteilers und des ADC's auch nach Umpolung unverändert verbunden bleiben.

7.  Vorrichtung nach Anspruch 6, bei welcher ein vom Spannungsteiler zum A/D-Wandler zugeführter Referenzspannungswert an einen Umschalter (4) angeschlossen ist, dessen Umschaltpunkt an eine weitere Zuleitung angeschlossen ist, und der Umschalter (4) beide an ihn angeschlossenen Signale wahlweise an den Eingang des ADC schaltet.

8.  Vorrichtung nach Anspruch 6 oder 7, bei welcher die Widerstände (R1, R2) des Spannungsteilers einer standardisierten Widerstandsreihe mit bekannten Fehlertoleranzwerten entnommen sind.

9.  Vorrichtung nach einem der Ansprüche 6 bis 8, bei welcher der Spannungsteiler mit beiden Widerständen (R1, R2), die beiden Umschalter (1, 2) des Spannungsteilers und der Eingangsschalter (4) des A/D-Wandlers auf einem gemeinsamen mit dem A/D-Wandler integrierten Halbleiterchip als Mikroschaltungsstruktur implementiert sind.

10. Vorrichtung nach einem der Ansprüche 6 bis 9, bei welcher die zwei Umschalter (1, 2) des Spannungsteilers und der Eingangsschalter (4) des A/D-Wandlers als elektronisch ansteuerbare Bauelemente ausgeführt sind.

11. Vorrichtung nach einem der Ansprüche 6 bis 10, bei welcher die zwei Umschalter (1, 2) des Spannungsteilers mechanisch miteinander gekoppelt sind.

**Europäisches Patentamt**

**EUROPÄISCHER RECHERCHENBERICHT**

Nummer der Anmeldung

EP 06 12 2391

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | OGLESBEE J: "VOLTAGE DIVIDER ERROR SELF CORRECTION METHOD FOR ANALOG TO DIGITAL (A/D) CONVERSION PRE-SCALER" MOTOROLA TECHNICAL DEVELOPMENTS, MOTOROLA INC. SCHAUMBURG, ILLINOIS, US, Bd. 34, März 1998 (1998-03), Seiten 71-72, XP000781026 ISSN: 0887-5286 * das ganze Dokument * ----- | 1-11 | INV. H03M1/10 G01R31/00 |
| Y | EP 1 394 558 A (CIT ALCATEL [FR]) 3. März 2004 (2004-03-03) * Spalte 7, Zeile 10 - Zeile 19; Abbildung 2 * ----- | 1-11 | |
| Y | WO 03/096540 A (CONTINENTAL TEVES AG & CO OHG [DE]; FEY WOLFGANG [DE]; ENGELMANN MARIO) 20. November 2003 (2003-11-20) * Seite 10, Zeile 21 - Zeile 29; Abbildungen 4,5 * ----- | 1-11 | |
| X | DE 197 05 406 A1 (TELEFUNKEN MICROELECTRON [DE]) 27. August 1998 (1998-08-27) | 5,7 | RECHERCHIERTE SACHGEBIETE (IPC) H03M G01R |
| Y | * Spalte 1, Zeile 22 - Zeile 26; Abbildung 2 * ----- | 1,2,6 | |
| X | DE 102 32 361 A1 (BOSCH GMBH ROBERT [DE]) 29. Januar 2004 (2004-01-29) | 5,8-11 | |
| Y | * Absatz [0023]; Abbildung 2 * ----- | 1,2,6 | |
| X | DE 199 12 766 A1 (CONTINENTAL TEVES AG & CO OHG [DE]) 8. Juni 2000 (2000-06-08) | 5 | |
| Y | * Spalte 6, Zeile 40 - Zeile 53 * ----- | 1,2,6 | |

Der vorliegende Recherchenbericht wurde für alle Patentansprüche erstellt

| Recherchenort | Abschlußdatum der Recherche | Prüfer |
|---|---|---|
| München | 24. Januar 2007 | Müller, Uta |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 06 12 2391

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

24-01-2007

| Im Recherchenbericht angeführtes Patentdokument | | Datum der Veröffentlichung | Mitglied(er) der Patentfamilie | | Datum der Veröffentlichung |
|---|---|---|---|---|---|
| EP 1394558 | A | 03-03-2004 | KEINE | | |
| WO 03096540 | A | 20-11-2003 | EP JP US | 1506616 A1 2005525038 T 2005190088 A1 | 16-02-2005 18-08-2005 01-09-2005 |
| DE 19705406 | A1 | 27-08-1998 | KEINE | | |
| DE 10232361 | A1 | 29-01-2004 | KEINE | | |
| DE 19912766 | A1 | 08-06-2000 | KEINE | | |

EPO FORM P0461

Für nähere Einzelheiten zu diesem Anhang : siehe Amtsblatt des Europäischen Patentamts, Nr.12/82